# EUROPÄISCHE PATENTSCHRIFT

(11) **EP 2 331 437 B1**
(45) Veröffentlichungstag und Bekanntmachung des Hinweises auf die Patenterteilung: **02.05.2018**
(21) Anmeldenummer: 09748942.1
(22) Anmeldetag: 27.08.2009
(51) Int. Cl.: B65G 49/06, H01L 21/00, H01L 21/677, H01L 21/67

(54) **VERFAHREN UND VORRICHTUNG ZUM ZWISCHENLAGERN VON GLASPLATTEN FÜR PHOTOVOLTAISCHE MODULE.**
PORCESS AND APPARATUS FOR INTERMEDIATE STORAGE OF GLASS SHEETS USED FOR PHOTOVOLTAIC MODULES
PROCÉDÉ ET APPAREIL DE STOCKAGE INTERMÉDIAIRE DE FEUILLES DE VERRE UTILISÉES POUR DES MODULES PHOTOVOLTAÏQUES

(30) Priorität: 02.09.2008 DE 102008045369
(43) Veröffentlichungstag der Anmeldung: 15.06.2011
(73) Patentinhaber: Grenzebach Maschinenbau GmbH, 86663 Asbach-Bäumenheim (DE)
(72) Erfinder: WEIGL, Helmut, 94315 Straubing (DE)
(74) Vertreter: Kindermann, Peter
(86) Internationale Anmeldenummer: PCT/DE2009/001203
(87) Internationale Veröffentlichungsnummer: WO 2010/025706

(56) Entgegenhaltungen:
- EP-A1- 1 647 532
- DE-A1-102005 060 452
- JP-A- 2001 253 536
- US-A1- 2004 111 823

## Beschreibung

Die Erfindung betrifft eine Vorrichtung und ein Verfahren zum Aufnehmen von Glasplatten von mindestens einer Fertigungslinie und insbesondere zum automatischen Zwischenlagern von Glasplatten für rechteckige photovoltaische Module, bestehend aus zwei aufeinander liegenden, gleich großen, Glasplatten mit einer Zwischenlage aus einer, die Glasplatten verbindenden Folie.

Moderne Glasfassaden sind vielfach nicht nur ein Funktionselement eines Baukörpers sondern dienen zunehmend auch zur solaren Stromerzeugung. Maßgeschneiderte Solarmodule ermöglichen die passgenaue Integration in Bauwerksraster und Profile. Semitransparente Solarzellen, aber auch opake Solarzellen mit transparenten Bereichen, lassen Photovoltaik - Verglasungen lichtdurchflutet erscheinen. Die Solarzellen übernehmen dabei häufig den gewünschten Effekt des Sonnen - und Blendschutzes.

Die Herstellung von solchen Photovoltaik - Anlagen erfordert Arbeitsbedingungen wie sie vor allem bei der Herstellung von Halbleitern und integrierten elektronischen Schaltungen üblich sind. Diese so genannten Reinraum - Bedingungen machen bei der Herstellung von Photovoltaik - Anlagen auch zusätzlich die Handhabung flächenmäßig großer stoßempfindlicher Glasplatten erforderlich.

Bei einem photovoltaischen Modul handelt es sich, von außen betrachtet, um die Verbindung einer Substratplatte aus Glas, eines photovoltaischen Elements und einer Glasplatte als Deckglas mittels einer, unter Wärmeeinwirkung diese Glasplatten verklebenden, Folie.

Bei der Herstellung solcher Module in einer großen Fabrikanlage werden die einzelnen Bestandteile, im Wesentlichen die Substratplatte und das Deckglas, oder auch das fertige photovoltaische Modul, auf Transportbändern an den jeweiligen Bestimmungsort verbracht. Dies kann gleichzeitig auf mehreren Fertigungslinien geschehen.

Tritt nunmehr an irgendeiner Stelle einer solchen Fabrikanlage eine nicht absehbare Unterbrechung auf, besteht die Notwendigkeit, die am Beginn der Unterbrechung auflaufenden Bestandteile der Fertigung an irgendeiner Stelle vorübergehend zu lagern. Dieser Vorgang der Zwischenlagerung muss schnell und sicher erfolgen, ohne dass der Fertigungsprozess an anderer Stelle mehr als nötig gestört wird.

Aus dem Stand der Technik ist aus der DE 197 12 368 A1 ein Verfahren zum Versetzen von Gegenständen von einer ersten Stelle zu einer zweiten Stelle unter Verwendung eines den Gegenstand während des Versetzens an sich bindenden Haltemechanismus bekannt, mit dem auf einfache Weise ein unter allen Umständen sicheres Versetzen von Gegenständen durchgeführt werden kann. Als zu versetzende Gegenstände werden dabei Glasscheiben genannt. Hierbei erfolgt das Heranfahren des Haltemechanismus an den zu versetzenden Gegenstand an die erste oder die zweite Stelle unter Berücksichtigung der tatsächlichen Lage und/oder Ausrichtung derselben, wobei der Haltemechanismus bei Bedarf unter Ausnutzung einer freien Drehbarkeit und / oder Schwenkbarkeit desselben um eine oder mehrere Achsen ausgerichtet wird. Genauer gesagt ist der zu versetzende Gegenstand eine Glasscheibe, die erste Stelle ein Inlader - Gestell, die zweite Stelle ein Förderband, und der Haltemechanismus ein Saugrahmen. Des Weiteren wird noch in Verbindung mit dem Haltemechanismus auf Signalisierungseinrichtungen, Entkopplungseinrichtungen, eine Erfassungseinrichtung und eine Steuereinrichtung verwiesen.

Eine Offenbarung besonderer Mittel zum schnellen, sicheren Erfassen und einer schnellen Aufnahme größerer Glasplatten findet sich in dieser Druckschrift jedoch nicht.

Die Druckschrift DE 10 2005 060 452 A1 zeigt eine Handhabungsvorrichtung für Flachmaterialien, umfassend einen Tragrahmen mit mindestens einem Saugrahmen mit, in einer Tragfläche angeordneten, evakuierbaren Saugköpfen zum Aufnehmen von ansaugbaren Flachmaterialien. Mit einer solchen Vorrichtung soll eine Handhabungsvorrichtung für Flachmaterialien bereitgestellt werden, die verschiedene Formate als auch beispielsweise beschichtete und unbeschichtete Flachmaterialien alternativ handhaben kann und dabei konstruktiv möglichst einfach gestaltet ist.

Hierzu ist der Tragrahmen zwischen einer im Wesentlichen vertikalen Position und einer im Wesentlichen horizontalen Position der Tragfläche verschwenkbar, wobei die Tragfläche wahlweise in eine horizontale Position mit nach oben oder eine horizontale Position mit nach unten weisenden Saugköpfen verschwenkbar ist. Auch in dieser Druckschrift findet sich keine Anregung zur Offenbarung besonderer Mittel zum schnellen, sicheren Erfassen und einer schnellen Aufnahme großer Glasplatten.

Aus der den Oberbegriff der unabhängigen Patentansprüche bildenden Druckschrift JP 2001 253536 ist eine Vorrichtung zum Aufnehmen von Glasplatten von mindestens einer Fertigungslinie zum weiteren Transport in ein Speichergehäuse mit den folgenden Merkmalen bekannt:
a) einer linear verfahrbaren, vertikal installierten Haupthubsäule mit einem vertikal daran verfahrbaren Hubrechen,
b) einem Horizontalantrieb des Hubrechens,
c) mindestens einem, an einer Gabel des Hubrechens angebrachten Sensor zur Detektion der Belegung des Hubrechens mit einer Glasplatte.

Aus der DE 10 205 060 452 A1 ist eine Handhabungsvorrichtung für Flachmaterialien mit einem Tragrahmen und einer Tragfläche bekannt, bei der der Tragrahmen zwischen einer vertikalen und einer horizontalen Position der Tragfläche verschwenkbar ist.

Aus der US 2004/0111823 A1 ist eine Detektions- und Reinigungsvorrichtung in einer Handhabungsvorrichtung für Photomasken bekannt.

Aus der US 5 980 197 A ist ein Verfahren zum automatischen Zwischenlegen von, einen Abstand haltenden, Rippen zwischen Glasplatten bekannt. Zu diesem Zweck werden im Wesentlichen die Glasplatten von Saugelementen und die Rippen von Greifern befördert und an entsprechender Stelle losgelassen. Eine besondere Schnelligkeit und Sorgfalt scheint bei diesem Vorgang nicht erforderlich.

Der vorliegenden Erfindung liegt deshalb die Aufgabe zugrunde, eine Vorrichtung und ein Verfahren bereitzustellen, mit dem die Zwischenlagerung auf der Fertigungslinie einlaufender Glasplatten schnell und sicher erfolgt, ohne dass der Fertigungsprozess an anderer Stelle mehr als nötig gestört wird.

Diese Aufgabe wird hinsichtlich der Vorrichtung durch die Merkmale des Anspruchs 1 und hinsichtlich des Verfahrens durch die Maßnahmen nach Anspruch 3 gelöst.

In den Unteransprüchen sind weitere vorteilhafte Ausführungsbeispiele der Erfindung gekennzeichnet.

Im Folgenden wird die Erfindung anhand von Figuren näher beschrieben.
Es zeigen im Einzelnen:
Fig.1: eine Schnittzeichnung der Gesamtvorrichtung
Fig.2: eine Schnittzeichnung des Speichergehäuses
Fig.3: eine Detailzeichnung der Haupthubsäule
Fig.4: ein Querschnitt durch die Haupthubsäule
Fig.5: eine perspektivische Darstellung des Hubrechens
Fig.6: zwei Querschnitte des Hubrechens
Fig.7: eine perspektivische Darstellung einer Hubvorrichtung
Fig.8: eine perspektivische Darstellung eines Beschickungsvorgangs
Fig.9: eine besondere Ausgestaltung eines Hubrechens

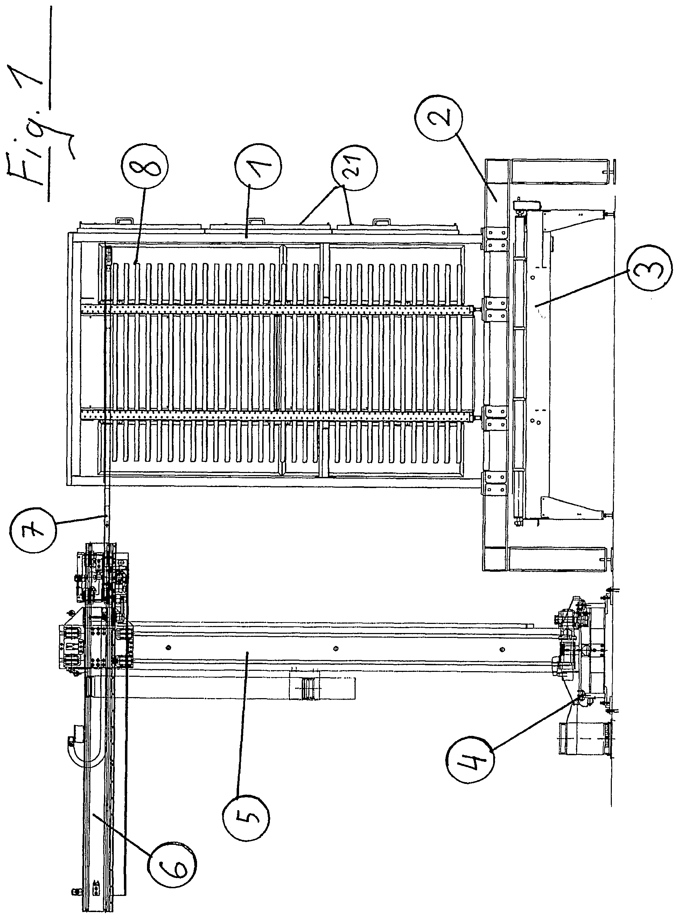

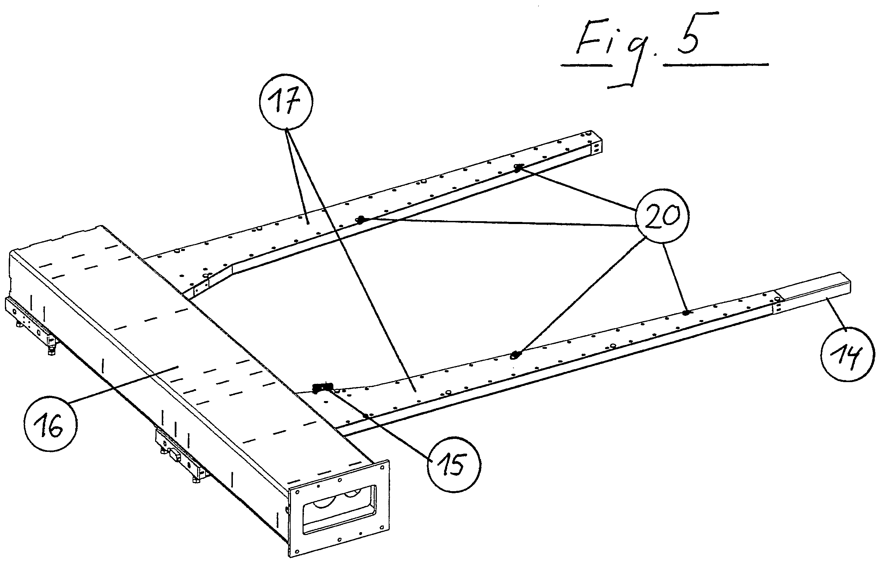

Fig.1 zeigt eine Schnittzeichnung der Gesamtvorrichtung. Das als Zwischenspeicher dienende Speichergehäuse (1) ist auf dem Speichersockel (2) befestigt unter dem ein Rollenförderer (3) durchläuft, von dem hier nur ein Teil dargestellt ist. Parallel zu der Längsseite des Speichergehäuses (1) verläuft eine Laufschiene (4) der Haupthubsäule (5).
Die Haupthubsäule (5) trägt die Horizontal - Verfahreinrichtung (6) für den Hubrechen (7). Der Hubrechen (7) befindet sich in der Fig. 1 in der obersten Stellung in der Höhe des obersten Stapelrechens (8) im Speichergehäuse (1). Das Speichergehäuse (1) weist an seiner Rückseite einige besondere Speicherzugänge (21) auf, über die die Möglichkeit besteht, Bruchglas manuell zu entfernen. Eine weitere erfindungsgemäße Möglichkeit Bruchglas automatisch zu entfernen, wird in der Fig.5 beschrieben.

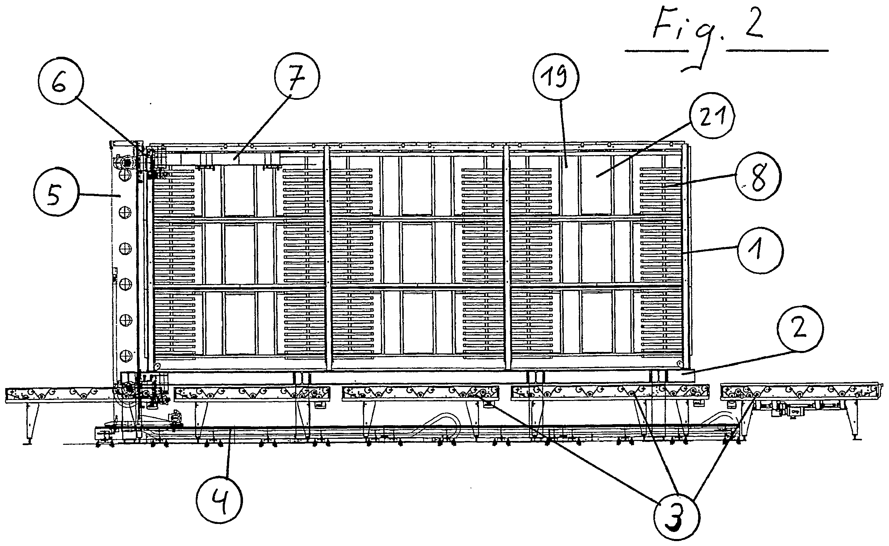

Fig.2 zeigt eine Schnittzeichnung des Speichergehäuses (1) mit dem zugehörigen Speichersockel (2). In der Darstellung der Fig.2 sind beispielhaft insgesamt 5 Rollenförderer (3) entsprechender Fertigungslinien gezeigt, von denen in der Fig.1 nur ein Teilstück einer Fertigungslinie gezeigt wurde. Am unteren Rand der Fig.2 ist eine Laufschiene (4) der Haupthubsäule (5) zu erkennen, wobei die Haupthubsäule (5) am linken Rand der Laufschiene (4) und des Speichergehäuses (1) dargestellt ist. Der Hubrechen (7) erstreckt sich in der Fig.2 auf der rechten Seite im rechten Winkel zur Haupthubsäule (5) und befindet sich hier in der obersten Stellung. Die Horizontal - Verfahreinrichtung (6) für den Hubrechen (7) ist von hinten zu erkennen. Ebenso ist die Rückwand (19) des Speichergehäuses (1) mit den besonderen Speicherzugängen (21) aus dieser Sicht von vorne zu sehen.

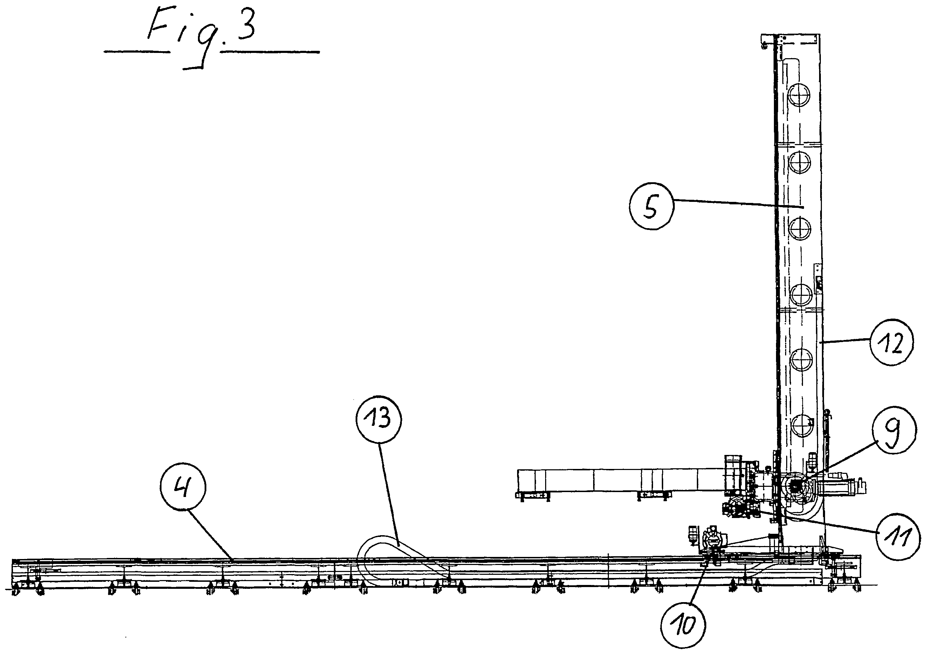

In der Fig.3 ist eine Detailzeichnung der Haupthubsäule (5) von der entgegengesetzten Seite wie in der Fig.2 dargestellt, wobei sich jedoch der Hubrechen (7) in einer unteren Position in Relation zum Speichergehäuse (1) befindet. Die Laufschiene (4) trägt hier den Horizontalantrieb (10) der Haupthubsäule (5). Die für diesen Antrieb benötigte Versorgungsleitung ist mit (13) bezeichnet. Der Servoantrieb (9) für die vertikale Bewegung des Hubrechens (7) und die technische Ausrüstung des Hubrechens (7) werden über die Versorgungsleitung (12) gesteuert.

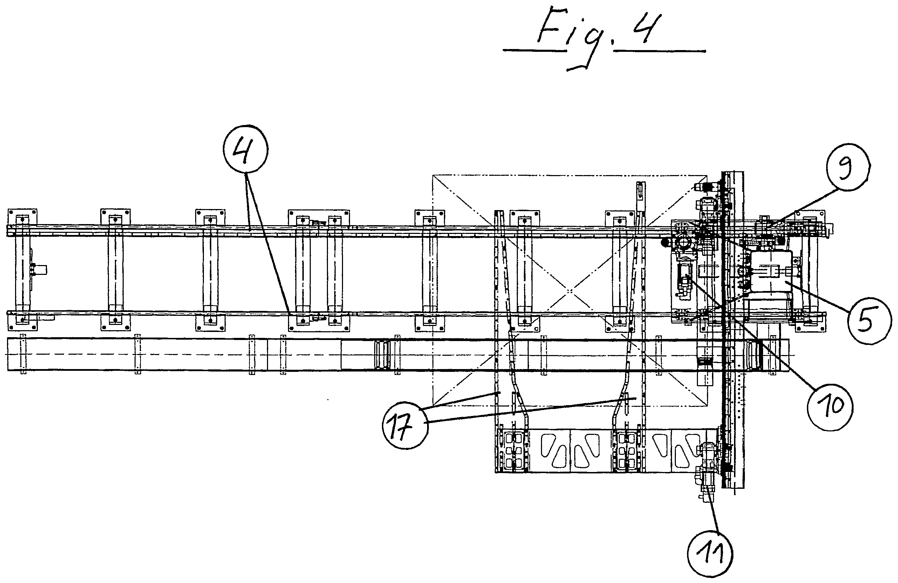

In der Fig.4 ist ein Querschnitt durch die Haupthubsäule (5) mit besonderer Sicht auf die Gabeln (17) des Hubrechens (7) gezeigt. Von oben sind hier die Laufschienen (4) und der Horizontalantrieb (10) der Haupthubsäule (5), sowie der Servoantrieb (9) für die vertikale Bewegung des Hubrechens (7) zu erkennen. Mit dem Horizontalantrieb (11) des Hubrechens (7) werden seine beiden Gabeln ( 17) in das Speichergehäuse (1) hinein gefahren und herausgefahren. Zur Aufnahme von Glasplatten und zum Abladen erfolgt steuerungstechnisch noch ein kurzes Anheben oder Absenken des Hubrechens (7).

Nähere Erläuterungen zu diesem Vorgang werden in der Fig.5 gegeben, die eine perspektivische Darstellung des Hubrechens (7) zeigt. Der Hubrechen (7) weist besondere Konstruktionsmerkmale auf, die ihn einerseits leicht und gleichzeitig gegen Verformungen relativ unempfindlich machen. Er ist in einer so genannten Wabenbauweise aus Stahlblech gefertigt. Diese Bauweise hat sich allen anderen Bauweisen, beispielsweise aus Aluminium oder Kevlar, für die vorliegenden Anforderungen als überlegen erwiesen.
Im Vordergrund ist der Querträger (16) als rechteckiger Kastenholm dargestellt, mit dem am linken Ende und am rechten Ende zwei Gabeln (17) verbunden sind. An dem schmalen Ende einer Gabel (17) des Hubrechens (7) ist ein Sensor (14) für die Speicherplatzbelegung im Speichergehäuse (1) vorgesehen. Der Sensor (14) kann auch zusätzlich an der anderen Gabel (17) angebracht werden. Beide Sensoren (14) können beispielsweise unterschiedliche Erfassungswinkel und / oder unterschiedliche Empfindlichkeits - Charakteristiken aufweisen, und sich auf diese Weise in der Wirkung ergänzen.

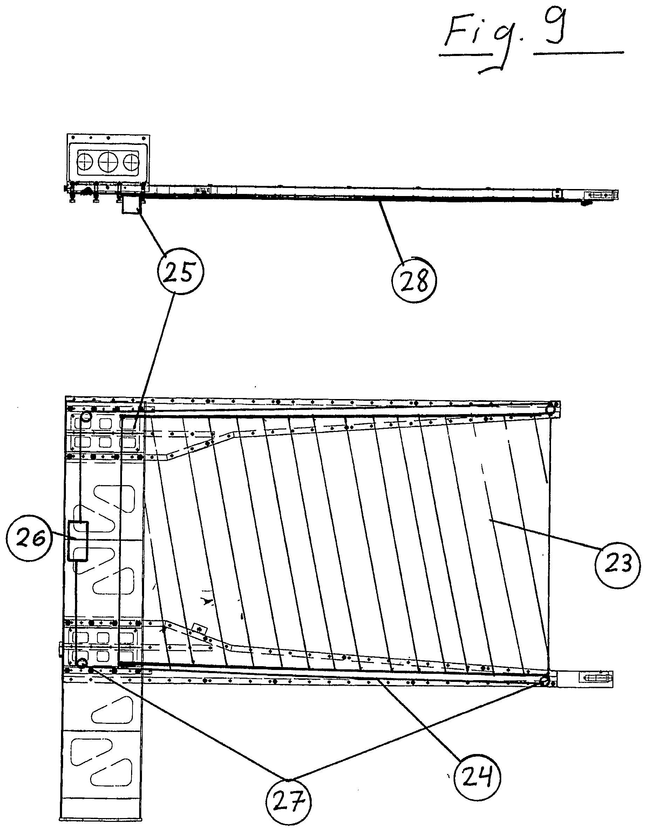

Das gleiche gilt für den Sensor (15) für die Detektion der Belegung des Hubrechens (7). Hier kann, im Verbund mit einem weiteren Sensor (15), zusätzliche Information darüber gewonnen werden, wie weit die betreffende Glasplatte auf dem Hubrechen aufliegt. Die genannten Sensoren können mit Ultraschall und / oder mit Licht arbeiten.
Die Bruchsensoren (20) durchleuchten die auf den Gabeln (17) aufliegenden Glasplatten an verschiedenen Stellen und in verschiedene Richtungen und ermitteln mittels des an Sprüngen auftretenden Streulichts ob die Glasplatte ein Bruchrisiko aufweist oder sogar schon gebrochen ist. In diesem Fall wird die beschädigte Glasplatte von dem Hubrechen (7) an eine hierfür vorgesehene Stelle zwischen den Fertigungslinien verbracht und dort entsorgt. Hierbei kann der Hubrechen (7) die beschädigte Glasplatte unter Zuhilfenahme der darunter liegenden Glasplatte aus dem Speichergehäuse (1) entfernen.
Eine weitere Möglichkeit besteht darin, zwischen den Gabeln (17) ein Netz aufzuspannen, das im Ernstfall die Bruchstücke aufnimmt. Hierzu wird an dieser Stelle an die Fig.9 verwiesen.
Ein manuelles Ausräumen des Speichergehäuses (1) mittels der besonderen Speicherzugänge (21) entfällt hiermit.

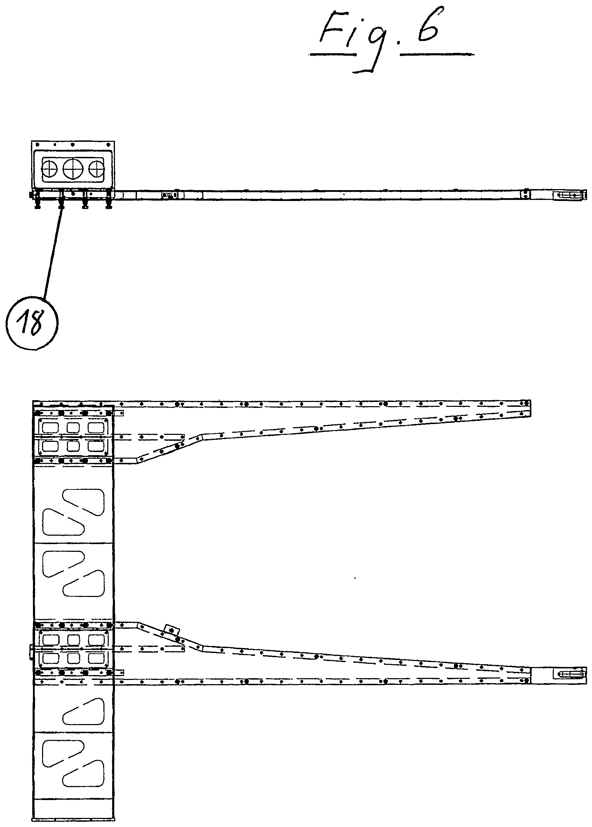

Inder Fig.6 ist der Hubrechen (7) in verschiedenen Ansichten im Querschnitt dargestellt. Zusätzlich sind hier die Befestigungselemente (18) der Gabeln (17) am Querträger (16) gekennzeichnet.

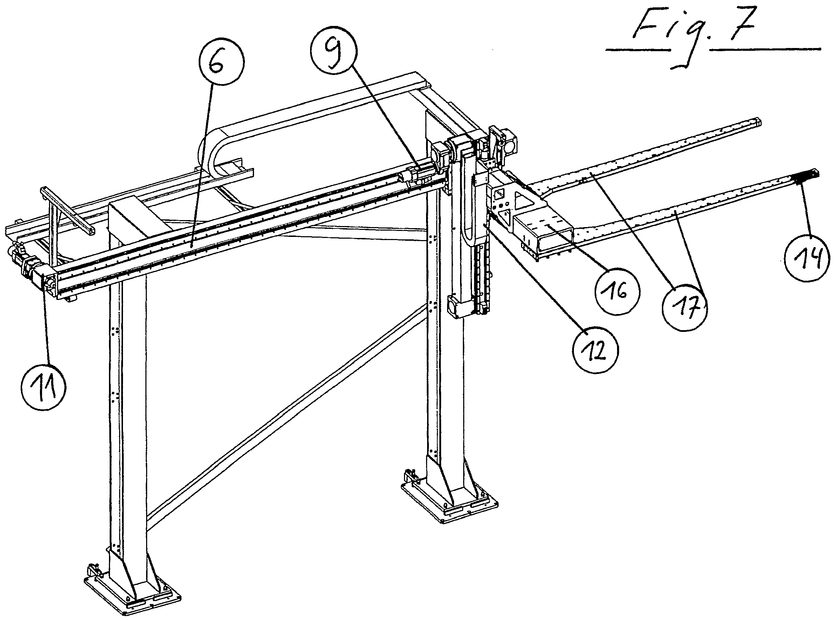

In der Fig.7 ist zur besseren Erkennbarkeit eine gesondert erfasste perspektivische Darstellung einer Hubvorrichtung gezeigt.
Hier ist zu erkennen dass die Horizontal - Verfahrvorrichtung (6) sich auf zwei Hubsäulen (5) stützt, die über quer verlaufende Verstrebungen verbunden sind. Der Horizontalantrieb (11) des Hubrechens (7), der diesen über einen Zahnriemen verfährt ist hier sehr deutlich gezeigt. Ebenso sind der Servoantrieb (9) für die vertikale Bewegung des Hubrechens (7).und die kettenartige Versorgungsleitung ( 12) für diese vertikale Bewegung und die Sensoren (14,15,20) zu erkennen.

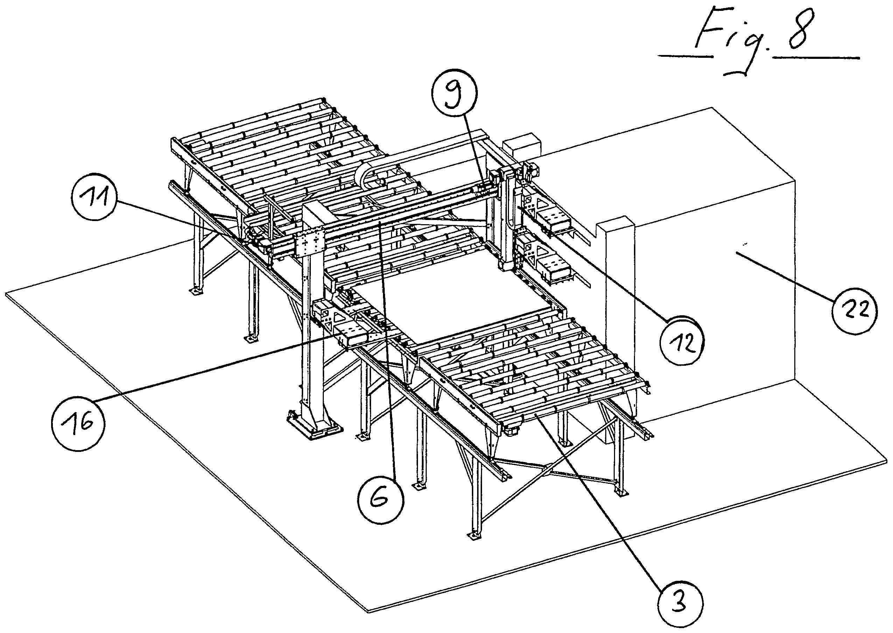

In der Fig. 8 ist die erfindungsgemäße Vorrichtung, die im Detail in der Fig.7 gezeigt wurde, in Verbindung mit einem Rollenförderer (3) beim Aufnehmen von Glasplatten von der Fertigungslinie zur Verlagerung in eine Beschichtungs - Station dargestellt. In dieser Darstellung ist im Bereich der Beschichtungs - Station (22) in zwei übereinander liegenden Ebenen jeweils ein Querträger (16) im eingefahrenen Zustand gezeigt.

In der Fig. 9 ist eine besondere Ausgestaltung eines Hubrechens (7) gezeigt, bei dem mittels eines aufspannbaren Netzes eine beschädigte Glasscheibe, oder Teile davon, leicht und kostengünstig entsorgt werden können.
In der Fig. 9 ist zu erkennen, dass die breiteren versteiften Enden der Gabeln (17) des Hubrechens (7) nicht nach innen weisen, sondern nach außen. Dies dient dem Zweck für das Aufspannen eines Netzes eine gleichmäßige rechteckige Fläche zu erhalten. Es wird angemerkt, dass ein Aufspannen eines Netzes auch bei dem Belassen der Konstruktion gemäß der Anordnung der Gabeln (17) wie sie in den Fig. 4 bis 7 gezeigt sind, möglich ist. In diesem Fall müsste jedoch die Netzführungsschiene (28) so gestaltet sein, dass sich insgesamt wieder ein Rechteck ergibt. Eine andere Möglichkeit bestünde darin, in diesem Fall ein elastisches Netz zu verwenden, das sich, geführt in der, der bestehenden Kontur folgenden, Netzführungsschiene (28) dem sich ändernden Abstand zwischen den beiden Gabeln (17) anpasst.
Im Bereich des Querträgers (16), der zwischen den beiden Gabeln (17) liegt ist, wie in der Fig.9 gezeigt, ein Netzbehälter (25) angebracht, der es ermöglicht, ein in ihm unter Federspannung gelagertes, zusammen gerolltes, Netz bis an die vordere Spitze der Gabeln (17) herauszuziehen. Dies geschieht mittels eines Seiltriebs (26 ) der zwei Teile eines, über Umlenkrollen (27) an der Spitze der Gabeln (17) geführtes, Zugseils (24) gegen die Kraft einer, in dem Netzbehälter (25) befindlichen, Zugfeder aus dem Netzbehälter (25) herauszieht. Mit diesem Zugseil ( 24) wird auch das Netz (23), geführt in der Netzführungsschiene (28), aus dem Netbehälter (25) herausgezogen. Im umgekehrten Fall unterstützt der Seiltrieb (26) mittels Umkehr der Drehrichtung das Aufwickeln des Netzes (23) im Netzbehälter ( 25). Eine an beiden Seiten der Innenkante der Gabeln (17) befestigte Netzführungsschiene (28) gewährleistet einen störungsfreien Betrieb.

Die interaktive Steuerung der Hubrechen (7) und der Elemente der Hubsäule (4) in Verbindung mit der Erfassung der Glasplatten, die Überwachung der Positionierung der Glasplatten über Laser und / oder Sensoren im Rahmen einer Herstellung von photovoltaischen Elementen über mehrere Fertigungslinien erfordert ein spezielles Steuerungsprogramm.

### Bezugszeichenliste

- (1): Speichergehäuse
- (2): Speichersockel
- (3): Rollenförderer (Fertigungslinie)
- (4): Laufschiene der Haupthubsäule
- (5): Haupthubsäule
- (6): Horizontal - Verfahreinrichtung für den Hubrechen
- (7): Hubrechen
- (8): Stapelrechen
- (9): Servoantrieb für vertikale Bewegung
- (10): Horizontalantrieb der Haupthubsäule
- (11): Horizontalantrieb des Hubrechens
- (12): Versorgungsleitung (Vertikale Bewegung und Hubrechen)
- (13): Versorgungsleitung (Haupthubsäule)
- (14): Sensor für die Speicherplatzbelegung
- (15): Sensor für die Hubrechenbelegung
- (16): Querträger des Hubrechens
- (17): Gabel des Hubrechens
- (18): Befestigungselement am Hubrechen
- (19): Rückwand des Speichers
- (20): Bruchsensor
- (21): besonderer Speicherzugang
- (22): Beschichtungs - Station
- (23): Netz
- (24): Zugseil
- (25): Netzbehälter
- (26): Seiltrieb
- (27): Umlaufrollen
- (28): Netzführungsschiene

## Patentansprüche

1. Vorrichtung zum Aufnehmen von Glasplatten von mindestens einer Fertigungslinie zum weiteren Transport in ein Speichergehäuse (1) oder eine Beschichtungsanlage (22), mit
a) einer linear verfahrbaren, vertikal installierten, Haupthubsäule (5) mit einem vertikal daran verfahrbaren Hubrechen (7),
b) einem Horizontalantrieb (11) des Hubrechens (7),
c) mindestens einem, an einer Gabel (17) des Hubrechens (7) angebrachten Sensor (15) zur Detektion der Belegung des Hubrechens (7) mit einer Glasplatte,
**dadurch gekennzeichnet**,
d) dass mindestens ein, an der Gabel (17) des Hubrechens (7) angebrachter Sensor (14) zur Detektion der Belegbarkeit des beabsichtigten Lagerplatzes der Glasplatte vorgesehen ist,
e) dass mindestens ein, an der Gabel (17) des Hubrechens (7) angebrachter Sensor (20) zur Detektion von Beschädigungen in der Glasplatte vorgesehen ist,
f) dass ein weiterer Sensor (14) zur Detektion der Belegbarkeit des beabsichtigten Lagerplatzes und / oder ein weiterer Sensor (15) zur Detektion der Belegung des Hubrechens zusätzlich an einer anderen Gabel (17) des Hubrechens angebracht ist, wobei beide gegenüberliegende Sensoren unterschiedliche Erfassungswinkel und / oder unterschiedliche Empfindlichkeits - Charakteristiken aufweisen,
g) dass die Sensoren (14, 15, 20) auf der Basis von Ultraschall - Effekten und / oder Lichteffekten arbeiten und deren Signale steuerungstechnisch verarbeitet werden,
h) dass zwischen den Gabeln (17) des Hubrechens (7) ein, in einem Netzbehälter im Bereiche des Querträgers (16) aufgerolltes, Netz mittels eines Seiltriebs (26) aufgespannt werden kann,
i) dass die Lage und die Art, sowie die eventuelle Geschwindigkeit der aufzunehmenden Glasplatte mittels Sensoren erfasst und steuerungstechnisch verarbeitet wird.

2. Vorrichtung nach Anspruch 1, **dadurch gekennzeichnet, dass** der Hubrechen (7) in Wabenbauweise aus Stahlblech gefertigt ist.

3. Verfahren zum Aufnehmen von Glasplatten von mindestens einer Fertigungslinie zum weiteren Transport in ein Speichergehäuse (1) oder eine Beschichtungsanlage (22), mit folgenden Merkmalen:
a) eine aufzunehmende Glasplatte wird in ihrer Positionierung von Sensoren erfasst und eine linear verfahrbare, vertikal installierte Haupthubsäule (5) wird an den entsprechenden Ort verfahren,
b) ein an der Haupthubsäule (5) angebrachter, vertikal an dieser verfahrbarer Hubrechen (7) wird auf die Höhe der aufzunehmenden Glasplatte verfahren,
c) der Hubrechen (7) wird mittels des Horizontalantriebs (10) unter die aufzunehmende Glasplatte verfahren, leicht angehoben, und dann mit der Glasplatte in die Ausgangsstellung verfahren,
d) der Hubrechen (7) wird in die gewünschte Höhe und die Haupthubsäule (5) an die gewünschte Stelle auf der Laufschiene (4) gefahren,
**dadurch gekennzeichnet**,
e) dass ein Sensor (14) zur Detektion der Belegbarkeit des beabsichtigten Lagerplatzes am Hubrechen (7) ermittelt, ob der gewünschte Lageplatz frei ist und eine Horizontal - Verfahreinrichtung (6) in diesem Fall die Glasplatte an ihren Platz fährt, im anderen Fall ein Steuerungsprogramm den nächsten freien Platz sucht, wobei mindestens ein an einer Gabel (17) des Hubrechens (7) angebrachter Sensor (20) zur Detektion von Beschädigungen in der Glasplatte vorgesehen ist ,
f) dass der Sensor (14) zur Detektion der Belegbarkeit des beabsichtigten Lagerplatzes und / oder ein Sensor (15) zur Detektion der Belegung des Hubrechens durch einen weiteren Sensor des gleichen Typs an einer anderen Gabel (17) des Hubrechens (7)ergänzt wird, wobei beide gegenüberliegende Sensoren unterschiedliche Erfassungswinkel und / oder unterschiedliche Empfindlichkeits - Charakteristiken aufweisen,
g) dass die Sensoren (14, 15, 20) auf der Basis von Ultraschall - Effekten und / oder Lichteffekten arbeiten und deren Signale steuerungstechnisch verarbeitet werden, und
h) dass mittels eines, zwischen den Gabeln (17) des Hubrechens (7) im Bereich des Querträgers aufgerollten Netzes beschädigte Glasplatten aufgenommen werden können, und
i) dass die Lage und die Art, sowie die eventuelle Geschwindigkeit der aufzunehmenden Glasplatte mittels Sensoren erfasst und steuerungstechnisch verarbeitet wird,
f) der Hubrechen (7) etwas abgesenkt und in seine Ausgangsstellung zurückgefahren wird.

4. Verfahren nach Anspruch 3, **dadurch gekennzeichnet,**
**dass** die Haupthubsäule (5) nicht nur entlang der Laufschiene (4) verfahrbar ist, sondern auch im rechten Winkel hierzu.

## Claims

1. Device for receiving glass sheets from at least one production line for further transportation into a storage housing (1) or a coating installation (22), having
a) a linearly movable, vertically installed main lifting column (5) with a lifting rack (7) which is vertically movable thereon,
b) a horizontal drive (11) of the lifting rack (7),
c) at least one sensor (15) which is mounted on a prong (17) of the lifting rack (7) and which serves for detecting the occupancy of the lifting rack (7) with a glass sheet, **characterized**
d) **in that** there is provided at least one sensor (14) which is mounted on the prong (17) of the lifting rack (7) and which serves for detecting the ability of the intended storage place for the glass sheet to be occupied,
e) **in that** there is provided at least one sensor (20) which is mounted on the prong (17) of the lifting rack (7) and which serves for detecting damage in the glass sheet,
f) **in that** a further sensor (14) for detecting the ability of the intended storage place to be occupied and/or a further sensor (15) for detecting the occupancy of the lifting rack is additionally mounted on another prong (17) of the lifting rack, wherein both oppositely positioned sensors have different detection angles and/or different sensitivity characteristics,
g) **in that** the sensors (14, 15, 20) work on the basis of ultrasound effects and/or light effects, and their signals are processed by way of control technology,
h) **in that** a netting which is rolled up in a netting container in the region of the cross-member (16) is able to be stretched between the prongs (27) of the lifting rack (7) by means of a rope drive (26),
i) **in that** the position and the type and, if appropriate, the speed of the glass sheet to be received are detected by means of sensors and processed by way of control technology.

2. Device according to Claim 1, **characterized in that** the lifting rack (7) is produced from sheet steel in honeycomb design.

3. Method for receiving glass sheets from at least one production line for further transportation into a storage housing (1) or a coating installation (22), having the following features:
a) the positioning of a glass sheet to be received is detected by sensors, and a linearly movable, vertically installed main lifting column (5) is moved to the corresponding location,
b) a lifting rack (7) which is mounted on the main lifting column (5) and which is vertically movable thereon is moved to the height of the glass sheet to be received,
c) the lifting rack (7) is moved under the glass sheet to be received by means of the horizontal drive (10), is raised slightly, and is then moved, together with the glass sheet, into the initial position,
d) the lifting rack (7) is moved to the desired height, and the main lifting column (5) is moved to the desired location on the running rail (4),
characterized
e) in that a sensor (14), on the lifting rack (7), for detecting the ability of the intended storage place to be occupied determines whether the desired storage place is free, and a horizontal movement device (6) moves the glass sheet to its place in this case, while a control program searches for the next free place in the other case, wherein there is provided at least one sensor (20) which is mounted on a prong (17) of the lifting rack (7) and which serves for detecting damage in the glass sheet,
f) in that the sensor (14) for detecting the ability of the intended storage place to be occupied and/or a sensor (15) for detecting the occupancy of the lifting rack is supplemented by a further sensor of the same type on another prong (17) of the lifting rack (7), wherein both oppositely positioned sensors have different detection angles and/or different sensitivity characteristics,
g) in that the sensors (14, 15, 20) work on the basis of ultrasound effects and/or light effects, and their signals are processed by way of control technology, and
h) in that damaged glass sheets are able to be received by means of a netting, which is rolled up between the prongs (17) of the lifting rack (7) in the region of the cross-member, and
i) in that the position and the type and, if appropriate, the speed of the glass sheet to be received are detected by means of sensors and processed by way of control technology,
f) the lifting rack (7) is lowered slightly and moved back into its initial position.

4. Method according to Claim 3, **characterized in that** the main lifting column (5) is movable not only along the running rail (4) but also at a right angle thereto.

## Revendications

1. Dispositif de réception de feuilles de verre d'au moins une ligne de fabrication en vue de leur transport ultérieur dans une enceinte de transport (1) ou une installation de revêtement (22), avec
a) une colonne de levage principale (5) déplaçable linéairement, installée verticalement, avec un râteau de levage (7) déplaçable verticalement sur celle-ci,
b) un entraînement horizontal (11) du râteau de levage (7),
c) au moins un détecteur (15) installé sur une fourche (17) du râteau de levage (7) pour la détection de l'occupation du râteau de levage (7) avec une feuille de verre,
**caractérisé en ce que**
d) il est prévu au moins un détecteur (14) installé sur la fourche (17) du râteau de levage (7) pour la détection de la disponibilité de l'emplacement de stockage envisagé de la feuille de verre,
e) il est prévu au moins un détecteur (20) installé sur la fourche (17) du râteau de levage (7) pour la détection de dommages dans la feuille de verre,
f) un autre détecteur (14) pour la détection de la disponibilité de l'emplacement de stockage envisagé et/ou un autre détecteur (15) pour la détection de l'occupation du râteau de levage est installé en outre sur une autre fourche (17) du râteau de levage, dans lequel les deux détecteurs opposés présentent des angles de détection différents et/ou des caractéristiques de sensibilité différentes,
g) les détecteurs (14, 15, 20) opèrent sur la base d'effets d'ultrasons et/ou d'effets de lumière et leurs signaux sont traités selon la technique de commande,
h) un filet enroulé dans un conteneur de filet dans la région de la traverse (16) peut être tendu entre les fourches (17) du râteau de levage (7) au moyen d'une transmission à câble (26),
i) la position et la nature, ainsi que la vitesse éventuelle de la feuille de verre à recevoir sont détectées au moyen de détecteurs et sont traitées selon la technique de commande.

2. Dispositif selon la revendication 1, **caractérisé en ce que** le râteau de levage (7) est fabriqué en tôle d'acier en mode nid d'abeilles.

3. Procédé de réception de feuilles de verre d'au moins une ligne de fabrication en vue de leur transport ultérieur dans une enceinte de stockage (1) ou une installation de revêtement (22), présentant les caractéristiques suivantes:
a) on détecte le positionnement d'une feuille de verre à recevoir au moyen de détecteurs et on déplace une colonne de levage principale (5) déplaçable linéairement, installée verticalement, à l'endroit correspondant,
b) on déplace à la hauteur de la feuille de verre à recevoir un râteau de levage (7) installé sur la colonne de levage principale (5) et déplaçable verticalement sur celle-ci,
c) on déplace le râteau de levage (7) au moyen de l'entraînement horizontal (10) sous la feuille de verre à recevoir, on le soulève légèrement, puis on le déplace avec la feuille de verre dans la position initiale,
d) on déplace le râteau (7) à la hauteur désirée et la colonne de levage principale (5) à l'endroit désiré sur le rail de roulement (4),
**caractérisé en ce que**
e) un détecteur (14) pour la détection de la disponibilité de l'emplacement de stockage envisagé sur le râteau de levage (7) détermine si l'emplacement de stockage désiré est libre et un dispositif de déplacement horizontal (6) amène dans ce cas la feuille de verre à son emplacement, dans le cas contraire un programme de commande recherche le prochain emplacement libre, dans lequel il est prévu au moins un détecteur (20) installé sur une autre fourche (17) du râteau de levage (7) pour la détection de dommages dans la feuille de verre,
f) le détecteur (14) pour la détection de la disponibilité de l'emplacement de stockage envisagé et/ou un détecteur (15) pour la détection de l'occupation du râteau de levage est complété par un autre détecteur du même type sur une autre fourche (17) du râteau de levage (7), dans lequel les deux détecteurs opposés présentent des angles de détection différents et/ou des caractéristiques de sensibilité différentes,
g) les détecteurs (14, 15, 20) opèrent sur la base d'effets d'ultrasons et/ou d'effets de lumière et leurs signaux sont traités selon la technique de commande, et
h) des feuilles de verre endommagées peuvent être reprises au moyen d'un filet enroulé entre les fourches (17) du râteau de levage (7) dans la région de la traverse, et
i) on détecte la position et la nature, ainsi que la vitesse éventuelle, de la feuille de verre à recevoir au moyen de détecteurs et on les traite selon la technique de commande,
f) on abaisse légèrement le râteau de levage (7) et on le ramène dans sa position initiale.

4. Procédé selon la revendication 3, **caractérisé en ce que** la colonne de levage principale (5) n'est pas déplaçable uniquement le long du rail de roulement (4), mais aussi perpendiculairement à celui-ci.
